# FASCICULE DE BREVET EUROPEEN

(11) **EP 1 932 104 B1**
(45) Date de publication et mention de la délivrance du brevet: **07.11.2012**
(21) Numéro de dépôt: 06794373.8
(22) Date de dépôt: 28.08.2006
(51) Int. Cl.: G06K 19/077

(54) **MODULE ÉLECTRONIQUE À DOUBLE INTERFACE DE COMMUNICATION, NOTAMMENT POUR CARTE À PUCE**
DOPPELSCHNITTSTELLEN-KOMMUNIKATIONS-ELEKTRONIKMODUL INSBESONDERE FÜR EINE CHIPKARTE
DOUBLE INTERFACE COMMUNICATION ELECTRONIC MODULE, IN PARTICULAR FOR A CHIP CARD

(30) Priorité: 30.08.2005 FR 0508860
(43) Date de publication de la demande: 18.06.2008
(73) Titulaire: Smart Packaging Solutions (SPS), 13106 Rousset (FR)
(72) Inventeur: ARTIGUE, Olivier, F-83160 La Valette du Var (FR); BOCCIA, Henri, F-13720 Belcodene (FR); BRUNET, Olivier, F-13012 Marseille (FR)
(74) Mandataire: Scheer, Luc
(86) Numéro de dépôt international: PCT/FR2006/002012
(87) Numéro de publication internationale: WO 2007/026077

(56) Documents cités:
- EP-A- 1 031 939
- DE-C1- 19 632 115
- FR-A- 2 765 010
- US-B1- 6 310 778
- US-B1- 6 719 206

## Description

L'invention concerne un module électronique à double interface de communication, notamment pour carte à puce, ledit module comportant d'une part un substrat pourvu d'un bornier de contacts électriques permettant un fonctionnement par contact avec les contacts d'un lecteur, et comportant d'autre part une antenne formée d'au moins une spire, et dont les bornes sont reliées aux bornes d'une puce microélectronique située sur une face du module.

L'invention concerne en outre une carte à puce à double mode de communication avec un lecteur, à savoir un mode à contact et un mode sans contact, mettant en oeuvre un module selon l'invention.

Il existe déjà dans l'état de la technique, des cartes à puce à fonctionnement mixte avec contact et sans contact, encore appelées cartes « dual interface » en terminologie anglo-saxonne. La plupart de ces cartes présente un module microélectronique pourvu de contacts, ledit module ayant une interface de communication radiofréquence connectée aux bornes d'une antenne qui est elle-même réalisée dans le corps de carte, et non pas sur le module lui-même.

Ainsi, les cartes à double interface de communication conformes à l'état de la technique sont constituées :
- d'un module électronique comportant la puce, le bornier de connexion à contact situé en face avant, et deux contacts situés en face arrière permettant la connexion à l'antenne.
- d'une carte plastiqué, comportant une antenne
- d'un matériau électriquement conducteur permettant la connexion entre le module électronique et l'antenne.

Cette structure procure en général une bonne portée de communication en fonctionnement, compte tenu de la taille importante de l'antenne, mais pose une série de problèmes de réalisation de la connexion mécanique et électrique entre l'antenne et le module, induisant des pertes de fiabilité ou de rendement de fabrication.

En effet, ces cartes sont généralement fabriquées suivant les étapes suivantes :
- fabrication du corps de carte comportant une antenne. Ces antennes peuvent être fabriquées en utilisant les méthodes connues utilisant des fils cuivre incrustés, ou l'impression d'encre conductrice ou la gravure de cuivre sur la matière interne du corps de carte.
- fabrication du micromodule électronique comportant des contacts sur une première et sur la seconde face, la puce et des points de connexion pour l'antenne.
- usinage dans le corps de carte de la cavité permettant le logement du micromodule électronique, tout en mettant à nu les plages de connexion de l'antenne située à l'intérieur du corps de carte.
- collage du micromodule électronique en établissant la connexion électrique entre celui-ci et les plages de connexion de l'antenne mises à nu.

Cette connexion peut être obtenue par des méthodes connues, comme la dispense de colle conductrice qui sera ensuite polymérisée, l'utilisation d'adhésif ou de pâtes conductrices de façon anisotrope (en épaisseur), ou l'utilisation d'un ressort polymère déposé sur le micromodule (plot conducteur en surépaisseur et compressible).

Ces méthodes de fabrication de ce type de cartes posent actuellement les problèmes suivants :
- nécessité de fabriquer des corps de cartes spécifiques pour les cartes « dual interface », comportant une antenne et induisant donc des procédés complexes de fabrication.
- nécessité d'usiner les corps de cartes en mettant à nu les plages de l'antenne, ce qui fait chuter les rendements de fabrication.
- utilisation d'un procédé de collage spécifique du micromodule électronique dans la carte spécifique permettant une interconnexion électrique du micromodule et de l'antenne.

Ces procédés sont souvent très lents en comparaison des procédés utilisés généralement pour les cartes à puce standards, et induisent des pertes supplémentaires de rendement de fabrication.

Les procédés d'interconnexion entre module et antenne utilisés limitent par conséquent fortement la fiabilité de la carte finale. En effet, les sollicitations mécaniques et thermiques infligées à la carte lors de son utilisation, entraînent des ruptures de connexion, ou des augmentations importantes de la résistance électrique de cette connexion, entraînant une perte de performance de la carte au cours de l'utilisation.

Ainsi, ce type de cartes ne peut pas être garantie sur un temps d'utilisation très long (supérieur à cinq ans par exemple), ce qui limite les applications disponibles pour ce type de cartes.

Pour pallier à ces problèmes de fabrication, on a pensé à intégrer l'antenne directement sur le module microélectronique, et à ensuite simplement reporter le module dans un corps de carte à puce, ce qui est aisé à réaliser avec un faible coût et une grande fiabilité, avec la plupart des machines d'encartage pour la fabrication des cartes à puce.

Une telle réalisation est décrite dans le EP 0 875 039 B1, en liaison avec sa figure 6A/6B qui est reproduite ci-après (figure 1A et 1B de la présente demande de brevet). Une réalisation similaire est décrite dans le FR 2 765 010 A. Comme cela sera décrit plus amplement par la suite, ces deux réalisations connues simplifient et fiabilisent la fabrication, mais introduisent un nouveau problème par rapport à la technologie précédente avec l'antenne dans le corps de carte. En effet, le module décrit dans ces documents présente un problème de fonctionnement dégradé en mode sans contact, du fait que l'antenne du module est réalisée sur une face du module, alors que les contacts électriques sont réalisés sur l'autre face du module, directement en regard de l'antenne. De ce fait, les contacts électriques étant métalliques, ils perturbent le flux électromagnétique entre le lecteur et l'antenne, au point de dégrader fortement la capacité de communication sans contact du module.

Un but de l'invention est par conséquent de proposer un module électronique à double interface de communication à contact et sans contact, qui soit dépourvu des inconvénients précités.

Un autre but de l'invention est de proposer une carte à puce à double interface de communication, utilisant un module électronique selon l'invention, et présentant une bonne capacité de communication en mode sans contact, malgré une grande compacité du module et de l'antenne.

Un autre but de l'invention est de proposer un module microélectronique à double interface de communication, notamment pour carte à puce, et une carte à puce utilisant un tel module, présentant une très grande fiabilité et une grande longévité, de l'ordre de cinq à dix ans.

A cet effet, l'invention prévoit un module électronique à double interface de communication, notamment pour carte à puce, tel que défini dans les revendications.

Le module selon l'invention comporte d'une part un substrat pourvu d'un bornier de contacts électriques permettant un fonctionnement par contact avec les contacts d'un lecteur, et comporte d'autre part une antenne pourvue d'au moins une spire, et dont les bornes sont reliées aux bornes d'une puce microélectronique située sur une face du module, les spires de l'antenne étant situées sensiblement en-dehors de la zone couverte par les contacts électriques.

De cette façon, les contacts électriques du bornier ne constituent pas un blindage électromagnétique pour les signaux destinés à l'antenne, et le fonctionnement du module en mode sans contact s'en trouve fortement amélioré.

De préférence, les contacts électriques du bornier sont situés sur une face du substrat, et les spires de l'antenne sont situées sur la face opposée.

De façon avantageuse, les spires de l'antenne sont situées en périphérie du module, et les contacts électriques du bornier sont situés à l'extérieur de la zone délimitée par les spires de l'antenne. Ainsi, le flux électromagnétique capté par les spires de l'antenne est maximal, ce qui influence favorablement la portée de la communication sans contact avec le lecteur. Dans ce mode de réalisation, les contacts électriques du bornier de contacts sont de préférence agencés pour être conformes à la norme ISO 7816-2.

Cependant, le mode de réalisation inverse de l'invention est possible ; les contacts électriques du bornier sont alors situés en périphérie du module, et les spires de l'antenne sont situées vers le centre du module, à l'intérieur de la zone délimitée par les contacts.

Avantageusement, les spires de l'antenne sont situées du même côté du substrat que la puce microélectronique, et les contacts électriques du bornier sont situés sur la face opposée du substrat.

Selon l'invention prenant en compte la fiabilité de la fabrication, le module présente une pluralité de protubérances situées en dehors de la zone couverte par les contacts et en regard des spires de l'antenne. Dans un mode de réalisation où l'antenne est en périphérie de la zone des contacts, les protubérances sont aussi réalisées en périphérie des contacts, en regard des spires de l'antenne, sur la face du substrat opposée à celle qui porte les spires de l'antenne, de sorte que les protubérances surplombent la zone des spires de l'antenne. Ainsi, la pression appliquée sur le module pendant l'intégration du module dans la cavité du corps de carte d'une carte à puce, est relayée par les protubérances jusqu'à la zone de collage entre le module et le corps de carte, ce qui garantit un collage de bonne qualité.

Ces protubérances sont de préférence métalliques et sont réalisées de façon très économique pendant la phase de réalisation des contacts électriques du bornier.

Elles ont par exemple sensiblement la forme de rayons s'étendant à partir des contacts électriques du bornier vers la périphérie du module.

Bien entendu, dans le cas où les protubérances sont métalliques, leur surface totale doit être faible par rapport à la surface des contacts du bornier, afin de ne pas ré-introduire des perturbations électromagnétiques, que la nouvelle structure du module a justement permis d'éliminer.

L'invention a également pour objet une carte à puce qui comporte un module électronique tel que décrit plus haut.

Dans une variante de cette carte à puce, elle comporte en outre dans son corps de carte, un dispositif de concentration ou d'amplification des ondes électromagnétiques, apte à canaliser le flux électromagnétique vers les spires de l'antenne.

D'autres caractéristiques et avantages de l'invention apparaîtront à la lecture de la description détaillée et des dessins annexés dans lesquels :
- la figure 1A illustre une vue en coupe d'un module électronique conforme à l'état de la technique selon EP 0 875 039 B1 ;
- la figure 1B illustre une vue en plan du module de la figure 1A ;
- la figure 2 illustre une vue de dessus d'un module électronique conforme à l'invention ;
- la figure 3 illustre une vue de dessous du module de la figure 2.
- la figure 4 illustre une vue en coupe du module des figures 3 et 4 ;
- la figure 5 illustre une vue en coupe d'une variante du module selon l'invention.

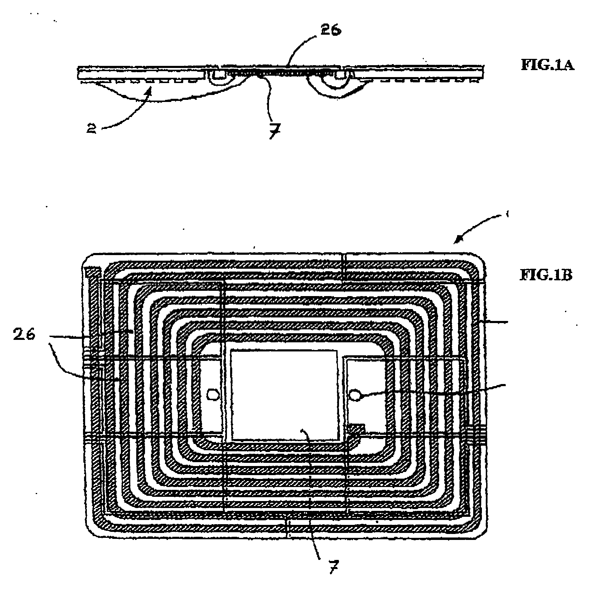

Comme indiqué plus haut, les figures 1A/1B montrent un module électronique à double interface, conforme à l'état de la technique. Les références numériques des figures 1A et 1B sont celles du document antérieur. On voit bien que la puce (notée 7) est connectée à une antenne (notée 2) dont les spires entourent la puce. Par ailleurs, comme visible en figure 1A, les contacts électriques (notés 26) surplombent l'antenne et ne sont séparés d'elle que par un mince substrat. Ainsi, le champ électromagnétique qui atteint l'antenne est nécessairement perturbé par les contacts électriques, ce qui dégrade le fonctionnement de ce type de module en mode sans contact.

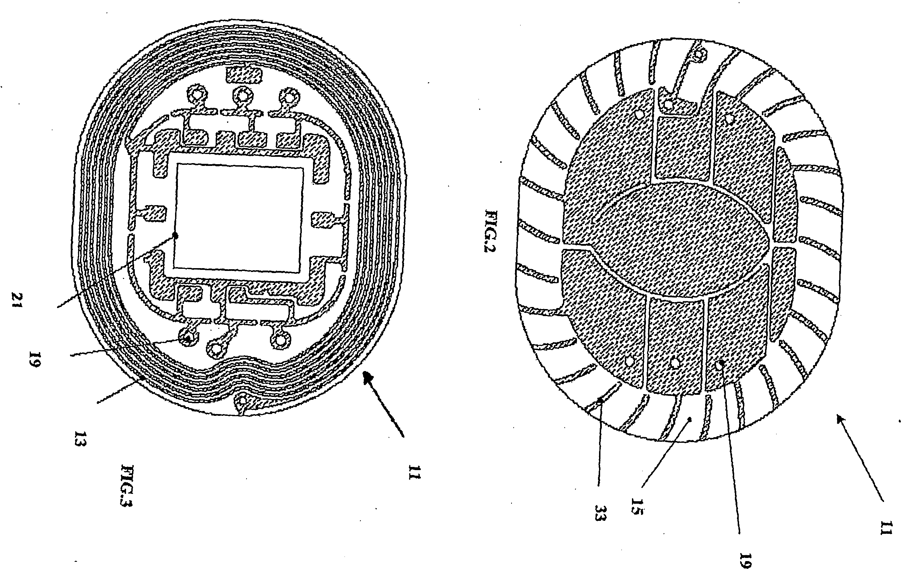

On se réfère aux figures 2 et 3. On a représenté dans ces figures un module électronique 11 conforme à l'invention, en vue de dessus (figure 2), c'est-à-dire une vue du côté des contacts, et en vue de dessous (figure 3), c'est-à-dire ici une vue du côté du substrat ne portant pas les contacts électriques.

Pour remédier aux problèmes d'interférence électromagnétique entre les contacts et l'antenne tel que décrit précédemment, les ingénieurs de la demanderesse ont trouvé une nouvelle structure de module 11, dans laquelle les spires 13 de l'antenne sont reportées à la périphérie 15 du module, dans une zone où elles ne sont situées ni en dessous ni au-dessus des contacts électriques 17, mais sensiblement à l'extérieur de la zone délimitée par les contacts.

En variante, les contacts électriques 17 peuvent être disposés en périphérie du module 11, et dans ce cas les spires de l'antenne seront disposées dans la zone centrale du module, toujours en-dehors de la zone des contacts.

On a représenté par ailleurs les puits ou vias 19 qui permettent de connecter électriquement les contacts de la puce (non représentée) aux contacts correspondants du bornier 17 du module 11. L'emplacement réservé au collage de la puce est noté 21 sur la figure 3.

Cette nouvelle structure présente l'avantage de minimiser voire d'éliminer les effets de blindage électromagnétique des contacts 17 à l'égard des spires 13 de l'antenne.

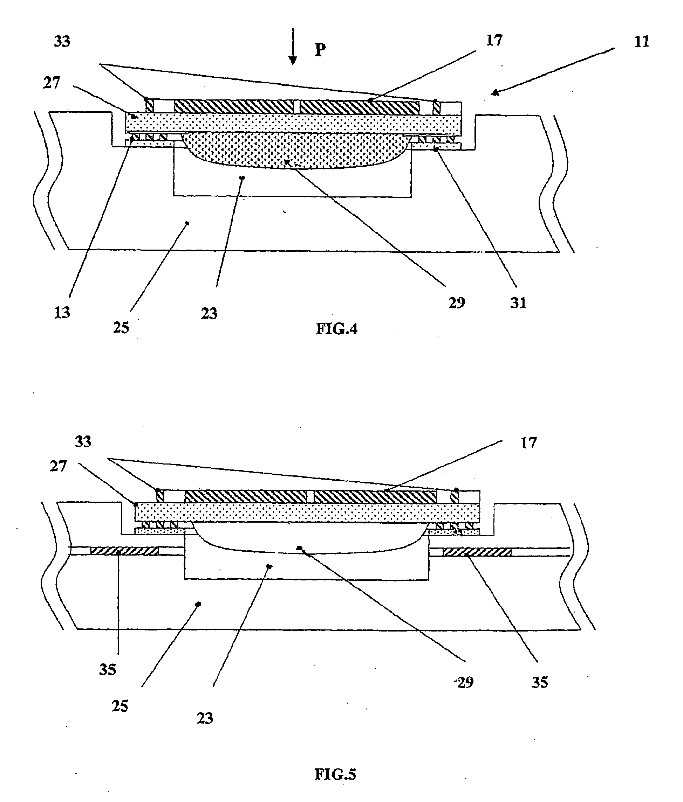

On se réfère à la figure 4. Le module 11 a été représenté dans cette figure avec son substrat 27, portant la puce (non représentée) sur sa face orientée vers le bas. La puce est ici cachée, car englobée dans une goutte de résine d'enrobage 29. L'antenne 13 est située à la périphérie du module 11, du côté de la puce et de sa résine d'enrobage 29 et elle s'étend autour de la puce. Selon l'invention, l'antenne s'étend hors de la zone centrale du module, qui est recouverte par les contacts 17 sur la face opposée (ici la face supérieure) du module 11.

Lors de l'assemblage de la carte à puce, le module 11 est reporté en face d'une cavité 23 aménagée dans le corps de carte 25. La cavité 23 est pourvue d'une zone revêtue d'un adhésif 31. Le module 11 est reporté dans la cavité comme représenté, les spires de l'antenne venant en contact avec l'adhésif 31. Il s'ensuit alors une étape de pressage sur la face supérieure du module 11, pour assurer un collage de bonne qualité du module 11 dans la cavité 23.

Cependant, il est possible que la structure de module selon l'invention rende la fabrication du module, et notamment cette étape de pressage, un peu plus délicate, comme cela peut être aisément compris sur la vue en coupe de la figure 4. En effet, le pressoir (représenté simplement par sa ligne d'action P) agit sur l'intégralité de la surface supérieure du module. Comme les spires 13 de l'antenne sont situées en-dehors de la zone des contacts 17, il n'y a pas d'action directe de pressage dans la zone située au-dessus des spires 13 de l'antenne, et par conséquent il y a potentiellement un risque de flexion du substrat 27, ou du moins d'un collage de moins bonne qualité entre les spires 13 et l'adhésif 31, ce qui nuirait à la fiabilité du collage et à la longévité de la carte.

Pour remédier à ce risque, l'invention prévoit, dans une variante encore plus avantageuse, une pluralité de protubérances 33 situées du côté des contacts électriques 17 mais dans la zone qui surplombe les spires 13 de l'antenne.

Ainsi, dans le mode de réalisation avec les spires 13 en périphérie du module, les protubérances 33 sont aussi en périphérie du module 11, du côté des contacts 17 et au-dessus des spires 13 de l'antenne. Ces protubérances 33 ont leur face supérieure située à la même hauteur que la face supérieure des contacts 17, de sorte que l'outil de pressage transmette la force de pressage en même temps sur les contacts et sur les protubérances 33, la force de pressage étant ainsi transmise à la zone de collage des spires 13 sur l'adhésif 31, sans que des flexions ou des déformations du module puissent apparaître.

Cette solution est bien sûr aisément adaptable à la variante du module qui comporte des contacts électriques en périphérie et l'antenne disposée en zone centrale du module.

De façon avantageuse et particulièrement simple, l'invention prévoit de réaliser les protubérances 33 à partir de la métallisation des contacts 17, par exemple par gravure chimique lors de la réalisation des contacts électriques 17. La forme des protubérances 33 sera aisément déterminée par l'homme du métier. Il est possible de donner aux protubérances 33 une forme de rayons légèrement incurvés, comme représenté en figure 2. Par ailleurs, pour le cas où les protubérances 33 sont métalliques (comme les contacts 17), il sera utile de minimiser leur surface autant que possible. En effet, elles sont situées dans la zone surplombant les spires 13 de l'antenne, et leur surface doit être relativement faible par rapport à la surface non métallisée, afin de minimiser toute interférence électromagnétique avec l'antenne. L'homme du métier sera aisément à même d'optimiser la surface des protubérances par rapport à la surface libre de métal, afin d'optimiser le flux électromagnétique capté par les spires de l'antenne, tout en permettant un pressage suffisant du module contre le corps de carte lors de l'encartage du module.

On se réfère maintenant à la figure 5, dans laquelle on a représenté une variante supplémentaire de l'invention, dans laquelle on a incorporé dans le corps de carte 25, un circuit résonnant 35 localisé sur tout ou partie du corps de carte. Ce circuit résonnant, qui peut notamment être constitué par une simple feuille métallique, présente des caractéristiques R,L,C aptes à canaliser le champ électromagnétique reçu par la carte à puce, vers l'antenne 13, de façon à encore améliorer la qualité du fonctionnement de la carte à puce en mode sans contact.

Ainsi, la carte destinée à recevoir le module peut avantageusement recevoir un dispositif de concentration ou d'amplification des ondes électromagnétiques, notamment de type circuit R,L,C, apte à canaliser le flux électromagnétique vers les spires de l'antenne. Ceci permettra une amélioration des performances de la carte finale. Il est à noter que dans cette configuration de l'invention, aucune interconnexion électrique entre le module électronique et ce dispositif d'amplification n'est à effectuer, ce qui permet de garder tous les avantages relatifs à la fiabilité et aux procédés de collages du module conforme à cette invention.

En définitive, l'invention propose une conception particulière permettant un fonctionnement optimal du module « dual interface », conçu de façon à laisser le flux électromagnétique passer à l'intérieur de l'antenne sans être perturbé par les métallisations des contacts, ce qui permet à l'antenne de réagir à ce flux, afin de fournir l'énergie suffisant à la communication radiofréquence de la puce.

Le module électronique de l'invention ne nécessite aucune connexion électrique avec le corps de carte, et les procédés standards d'encartage peuvent être utilisés, ce qui entraîne un gain de cadence de fabrication, une augmentation des rendements de fabrication et de la fiabilité. Ceci permet d'appliquer cette technologie à des applications terrain très sévères, ou de très longue durée de vie, comme par exemple l'application à des cartes d'identité ou des passeports électroniques, pour lesquels les offices gouvernementaux exigent en général une garantie de bonne tenue et de bon fonctionnement pendant dix ans.

## Revendications

1. Module électronique (11) à double interface de communication, notamment pour carte à puce, ledit module comportant d'une part un substrat (27) pourvu d'un bornier de contacts électriques (17) permettant un fonctionnement par contact avec les contacts d'un lecteur, et comportant d'autre part une antenne comportant au moins une spire (13), et dont les bornes sont reliées aux bornes d'une puce microélectronique située sur une face du module, les spires (13) de l'antenne étant situées sensiblement en-dehors de la zone couverte par les contacts électriques (17), **caractérisé en ce qu'**il présente une pluralité de protubérances (33) situées en dehors de la zone des contacts électriques (17) du bornier, sur la face du substrat (27) opposée à celle qui porte les spires de l'antenne.

2. Module électronique (11) selon la revendication 1, **caractérisé en ce que** les protubérances (33) sont situées en périphérie du module électronique et surplombent la zone des spires (13) de l'antenne.

3. Module électronique (11) selon la revendication 2, **caractérisé en ce que** les protubérances (33) sont métalliques et sont réalisées pendant la phase de réalisation des contacts électriques (17) du bornier.

4. Module électronique (11) selon la revendication 3, **caractérisé en ce que** les protubérances (33) ont sensiblement la forme de rayons s'étendant à partir des contacts électriques (17) du bornier vers la périphérie du module, la surface totale des protubérances (33) étant faible par rapport à la surface des contacts (17) du bornier.

5. Module électronique (11) selon l'une des revendications 1 à 4, **caractérisé en ce que** les contacts électriques (17) du bornier sont situés sur une face du substrat (27), et **en ce que** les spires (13) de l'antenne sont situées sur la face opposée du substrat.

6. Module électronique (11) selon la revendication 5, **caractérisé en ce que** les spires (13) de l'antenne sont situées en périphérie du module, et **en ce que** les contacts électriques (17) du bornier sont situés vers le centre du module, à l'extérieur de la zone délimitée par les spires de l'antenne.

7. Module électronique (11) selon l'une quelconque des revendications 1 à 6, **caractérisé en ce que** les spires (13) de l'antenne sont situées du même côté du substrat (27) que la puce microélectronique, les contacts électriques (17) du bornier étant situés sur la face opposée du substrat.

8. Module électronique (11) selon l'une quelconque des revendications 1 à 7, **caractérisé en ce que** les contacts électriques (17) du bornier de contacts sont agencés pour être conformes à la norme ISO 7816-2.

9. Module électronique (11) selon l'une quelconque des revendications 1 à 5, 7, 8, **caractérisé en ce que** les contacts électriques (17) du bornier sont situés en périphérie du module, et **en ce que** les spires (13) de l'antenne sont situées vers le centre du module, à l'extérieur de la zone délimitée par les contacts électriques (17).

10. Carte à puce, **caractérisée en ce qu'**elle comporte un module électronique (11) selon l'une quelconque des revendications précédentes.

11. Carte à puce selon la revendication 10, **caractérisée en ce qu'**elle comporte en outre dans le corps de carte, un dispositif de concentration ou d'amplification des ondes électromagnétiques, apte à canaliser le flux électromagnétique vers les spires (13) de l'antenne.

## Claims

1. An electronic module (11) with double communication interface, in particular for a chip card, the said module comprising firstly a substrate (27) provided with an electrical contact terminal block (17) allowing functioning by contact with the contacts of a reader and secondly comprising an antenna provided with at least one turn (13) and whose terminals are connected to the terminals of a microelectronic chip situated on one face of the module, the turns (13) of the antenna being situated substantially outside the area covered by the electrical contacts (17, said module being **characterised in that** it has a plurality of protuberances (33) situated outside the area of electrical contacts (17) of the terminal block, on the face of the substrate (27) opposite to the one that carries the antenna turns.

2. An electronic module (11) according to claim 1, **characterised in that** the protuberances (33) are situated at the periphery of the electronic module and overhang the area of the antenna turns (13).

3. An electronic module (11) according to claim 2, **characterised in that** the protuberances (33) are metallic and are produced during the phase of producing the electrical contacts (17) of the terminal block.

4. An electronic module (11) according to claim 3, **characterised in that** the protuberances (33) are substantially in the form of radii extending from the electrical contacts (17) of the terminal block towards the periphery of the module, the total surface area of the protuberances (33) being small compared with the surface area of the contacts (17) of the terminal block.

5. An electronic module (11) according to anyone of claims 1 to 4, **characterised in that** the electrical contacts (17) of the terminal block are situated on one face of the substrate (27), and **in that** the antenna turns (13) are situated on the opposite face of the substrate.

6. An electronic module (11) according to claim 5, **characterised in that** the antenna turns (13) are situated at the periphery of the module and **in that** the electrical contacts (17) of the terminal block are situated towards the centre of the module, outside the area delimited by the antenna turns.

7. An electronic module (11) according to any one of claims 1 to 6, **characterised in that** the antenna turns (13) are situated on the same side of the substrate (27) as the microelectronic chip, the electrical contacts (17) of the terminal block being situated on the opposite face of the substrate.

8. An electronic module (11) according to any one of claims 1 to 7, **characterised in that** the electrical contacts (17) of the contact terminal block are arranged so as to be in accordance with ISO 7816-2.

9. An electronic module (11) according to anyone of claims 1 to 5, 7 or 8, **characterised in that** the electrical contacts (17) of the terminal block are situated at the periphery of the module and **in that** the antenna turns (13) are situated towards the centre of the module, outside the area delimited by the electrical contacts (17).

10. A chip card **characterised in that** it comprises an electronic module (11) according to any one of the preceding claims.

11. A chip card according to claim 10, **characterised in that** it also comprises, in the card body, a device for concentrating or amplifying electromagnetic waves, able to channel the electromagnetic flux to the turns (13) of the antenna.

## Patentansprüche

1. Elektronisches Modul (11) mit doppelter Kommunikationsschnittstelle, insbesondere für eine Chipkarte, wobei das Modul einerseits ein Substrat (27), das mit einer Klemmenleiste von elektrischen Kontakten (17) versehen ist, die einen Betrieb durch Kontakt mit den Kontakten eines Lesegeräts erlauben, und andererseits eine Antenne aufweist, die mindestens eine Windung (13) aufweist und deren Klemmen mit den Klemmen eines mikroelektronischen Chips verbunden sind, der sich auf einer Seite des Moduls befindet, wobei die Windungen (13) der Antenne sich im Wesentlichen außerhalb des Bereichs befinden, der von den elektrischen Kontakten (17) bedeckt wird, **dadurch gekennzeichnet, dass** es eine Vielzahl von Vorsprüngen (33) aufweist, die sich außerhalb des Bereichs der elektrischen Kontakte (17) der Klemmenleiste auf der Seite des Substrats (27) befinden, die derjenigen entgegengesetzt liegt, die die Windungen der Antenne trägt.

2. Elektronisches Modul (11) nach Anspruch 1, **dadurch gekennzeichnet, dass** die Vorsprünge (33) sich am Umfang des elektronischen Moduls befinden und den Bereich der Windungen (13) der Antenne überlagern.

3. Elektronisches Modul (11) nach Anspruch 2, **dadurch gekennzeichnet, dass** die Vorsprünge (33) aus
Metall sind und während der Herstellungsphase der elektrischen Kontakte (17) der Klemmenleiste hergestellt werden.

4. Elektronisches Modul (11) nach Anspruch 3, **dadurch gekennzeichnet, dass** die Vorsprünge (33) im Wesentlichen die Form von Strahlen haben, die sich ausgehend von den elektrischen Kontakten (17) der Klemmenleiste zum Umfang des Moduls erstrecken, wobei die Gesamtfläche der Vorsprünge (33) bezüglich der Fläche der Kontakte (17) der Klemmenleiste gering ist.

5. Elektronisches Modul (11) nach einem der Ansprüche 1 bis 4, **dadurch gekennzeichnet, dass** die elektrischen Kontakte (17) der Klemmenleiste sich auf einer Seite des Substrats (27) befinden, und dass die Windungen (13) der Antenne sich auf der entgegengesetzten Seite des Substrats befinden.

6. Elektronisches Modul (11) nach Anspruch 5, **dadurch gekennzeichnet, dass** die Windungen (13) der Antenne sich am Umfang des Moduls befinden, und dass die elektrischen Kontakte (17) der Klemmenleiste sich zur Mitte des Moduls hin außerhalb des Bereichs befinden, der von den Windungen der Antenne begrenzt wird.

7. Elektronisches Modul (11) nach einem der Ansprüche 1 bis 6, **dadurch gekennzeichnet, dass** die Windungen (13) der Antenne sich auf der gleichen Seite des Substrats (27) befinden wie der mikroelektronische Chip, wobei die elektrischen Kontakte (17) der Klemmenleiste sich auf der entgegengesetzten Seite des Substrats befinden.

8. Elektronisches Modul (11) nach einem der Ansprüche 1 bis 7, **dadurch gekennzeichnet, dass** die elektrischen Kontakte (17) der Klemmenleiste von Kontakten ausgebildet sind, um der Norm ISO 7816-2 zu entsprechen.

9. Elektronisches Modul (11) nach einem der Ansprüche 1 bis 5, 7, 8, **dadurch gekennzeichnet, dass** die elektrischen Kontakte (17) der Klemmenleiste sich am Umfang des Moduls befinden, und dass die Windungen (13) der Antenne sich zur Mitte des Moduls hin außerhalb des von den elektrischen Kontakten (17) begrenzten Bereichs befinden.

10. Chipkarte, **dadurch gekennzeichnet, dass** sie ein elektronisches Modul (11) nach einem der vorhergehenden Ansprüche aufweist.

11. Chipkarte nach Anspruch 10, **dadurch gekennzeichnet, dass** sie außerdem in dem Kartenkörper eine Vorrichtung zur Konzentration oder Verstärkung der elektromagnetischen Wellen aufweist, die den elektromagnetischen Fluss zu den Windungen (13) der Antenne kanalisieren kann.
